# EUROPEAN PATENT SPECIFICATION

(11) **EP 4 379 782 B1**
(45) Date of publication and mention of the grant of the patent: **04.11.2026**
(21) Application number: 23213332.2
(22) Date of filing: 30.11.2023
(51) Int. Cl.: H10P 72/00

(54) **HEATER LIFE PREDICTION METHOD, HEAT TREATMENT APPARATUS, AND HEATER LIFE PREDICTION PROGRAM**
VERFAHREN ZUR VORHERSAGE DER LEBENSDAUER EINES HEIZELEMENTS, WÄRMEBEHANDLUNGSGERÄT UND PROGRAMM ZUR VORHERSAGE DER LEBENSDAUER DES HEIZELEMENTS
MÉTHODE DE PRÉDICTION DE LA DURÉE DE VIE D'UN ÉLÉMENT CHAUFFANT, APPAREIL DE TRAITEMENT THERMIQUE ET PROGRAMME DE PRÉDICTION DE LA DURÉE DE VIE DE L'ÉLÉMENT CHAUFFANT

(30) Priority: 01.12.2022 JP 2022193000
(43) Date of publication of application: 05.06.2024
(73) Proprietor: NuFlare Technology, Inc., Yokohama-shi, Kanagawa 235-8522 (JP)
(72) Inventor: WATANABE, Toru, Yokohama-shi, Kanagawa (JP); DAIGO, Yoshiaki, Yokohama-shi, Kanagawa (JP)
(74) Representative: Hoffmann Eitle

(56) References cited:
- JP-A- 2011 108 596
- US-A1- 2005 056 635

## Description

### FIELD

The present invention relates to a heater life prediction method, a heat treatment apparatus, and a heater life prediction program.

### BACKGROUND

A resistive heater (hereinafter, also "heater") constituted of carbon and the like, which is used in environments where hydrogen (H₂) gas is primarily adopted as the atmosphere gas often deteriorates with progress of a chemical reaction between the heater and a reactive gas, and finally fractures. If a heater provided in a film forming apparatus that forms a film on the surface of a substrate unexpectedly fractures, various problems such as defective products or unforeseen addressing of apparatus restoration occur. This results in a great decrease in the productivity of the film forming apparatus. Therefore, establishment of a method that can prevent unexpected fracture of a heater is demanded.

In order to prevent unexpected fracture of a heater, techniques of predicting the life of a heater using the resistance value of the heater have been proposed in, for example, JPA2009-245978 and JPA2011-108596.

That is, JPA2009-245978 proposes a system that reads continuous changes of the resistance value of a heater while the heater is energized, and issues an alarm when the read resistance value exceeds a preset threshold (for example, see paragraph 0029). However, the treatment steps for a wafer include a temperature increasing step and a temperature decreasing step for the wafer, a film forming step where conditions may change according to wafers, and the like, and the temperature of the heater changes throughout the steps of the wafer treatment. Therefore, the resistance value of the heater also fluctuates. Accordingly, it is difficult to set an appropriate threshold for all the steps as an index for heater fracture during energization of the heater.

In JPA2011-108596, the life of a heater is predicted by obtaining a difference between an actually-measured value of the resistance value of the heater and an initial or theoretical value of the resistance value of the heater, and comparing the difference with a preset threshold as an index for heater fracture (for example, see paragraphs 0063 and 0064). However, a resistance temperature coefficient at a certain temperature of the heater needs to be obtained to calculate the theoretical value of the resistance value of the heater and a thermocouple is used to measure the temperature of the heater (for example, see paragraph 0023). Extra cost is generated by installation of the thermocouple in a film forming apparatus, and the thermocouple may become a generation source of metallic contamination in the apparatus.

US 2005/056635 A1 relates to a device for determining a deterioration degree of a heater that heats a furnace. The device includes a current detector 21 that detects a level of a current flowing through a heater 7 that is heated based on a commercial power source 1; a voltage detector 20 that detects a level of a voltage applied to the heater 7; a temperature detector 22 that detects a temperature of the heater 7; a table memory 14 on which a temperature coefficient of resistance for use in calculation of a resistance of the heater 7 at a time of manufacture is stored; and a CPU 17A that calculates a resistance of the heater 7 at an inspection time based on respective detection results by the voltage detector 20 and the current detector 21 and calculates the resistance of the heater 7 at a reference time based on a detection result by the temperature detector 22 and the temperature coefficient of resistance stored on the table memory 14.

### BRIEF DESCRIPTION OF THE DRAWINGS

FIG. 1 is a diagram illustrating a film forming apparatus according to a first embodiment;
FIG. 2 is a diagram illustrating a wafer temperature and apparent power throughout wafer processing steps;
FIG. 3 is a graph illustrating a time change in the wafer temperature for each run in a loading step and a temperature increasing step;
FIG. 4 is a graph illustrating changes of a resistance value according to the number of runs for each heater as a comparative example;
FIG. 5 is a graph illustrating changes of a resistance increase amount according to the number of runs for each heater according to the present embodiment;
FIG. 6 is a graph illustrating changes of a resistance increase rate according to the number of runs for each heater according to the present embodiment;
FIG. 7 is a graph illustrating changes of a resistance value according to the number of runs for each heater according to a comparative example;
FIG. 8 is a graph illustrating changes of a resistance increase amount according to the number of runs for each heater according to the present embodiment;
FIG. 9 is a graph illustrating changes of a resistance increase rate according to the number of runs for each heater according to the present embodiment; and
FIG. 10 is a flowchart illustrating a heater life prediction method according to the present embodiment.

### DETAILED DESCRIPTION

The object of the invention is achieved by the subject-matter of the independent claims. Advantageous embodiments are defined in the dependent claims. Further examples are provided for facilitating the understanding of the invention.

A heater life prediction method according to the present disclosure includes predicting a life of a heater in a semiconductor manufacturing apparatus including a treatment chamber in which a treatment of a substrate is performed, and the heater configured to heat the substrate loaded into the treatment chamber, characterized in that prediction of the life of the heater includes: calculating a resistance change amount being a difference between a resistance value of the heater and an initial value of the resistance value, or a resistance change rate obtained by dividing the resistance change amount by the initial value in a step in which constant output control is executed on the heater between the treatments of different substrates; and predicting the life of the heater on a basis of the calculated resistance change amount or the calculated resistance change rate.

In the heater life prediction method described above, it is possible to configure that the life of the heater is predicted based on a relation between the resistance change amount or the resistance change rate and a preset threshold.

In the heater life prediction method described above, it is possible to further include notifying a user that the heater is close to an end of the life.

In the heater life prediction method described above, it is possible to configure that the step in which the constant output control is executed is at least one of a film forming step of forming a film on the substrate, a temperature decreasing step of decreasing a temperature of the substrate, and an unloading step of unloading the substrate from the treatment chamber.

A heat treatment apparatus according to the present disclosure includes: a treatment chamber in which a treatment of a substrate is performed; a heater configured to heat the substrate loaded into the treatment chamber; and a life predictor configured to predict a life of the heater, characterized in that the life predictor calculates a resistance change amount being a difference between a resistance value of the heater and an initial value of the resistance value, or a resistance change rate obtained by dividing the resistance change amount by the initial value in a step in which constant output control is executed on the heater between the treatments of different substrates, and predicts the life of the heater on a basis of the calculated resistance change amount or the calculated resistance change rate.

In the heat treatment apparatus described above, it is possible to configure that the life predictor predicts the life of the heater on a basis of a relation between the calculated resistance change amount or the calculated resistance change rate and a preset threshold.

In the heat treatment apparatus described above, it is possible to configure that the life predictor notifies a user that the heater is close to an end of the life.

In the heat treatment apparatus described above, it is possible to configure that the step in which the constant output control is executed is at least one of a film forming step of forming a film on the substrate, a temperature decreasing step of decreasing a temperature of the substrate, and an unloading step of unloading the substrate from the treatment chamber.

A heater life prediction program according to the present disclosure causes a computer to perform a procedure for predicting a life of a heater in a heat treatment apparatus including a treatment chamber in which a treatment of a substrate is performed, and the heater configured to heat the substrate loaded into the treatment chamber, characterized in that the procedure including: calculating a resistance change amount being a difference between a resistance value of the heater and an initial value of the resistance value, or a resistance change rate obtained by dividing the resistance change amount by the initial value in a step in which constant output control is executed on the heater between the treatments of different substrates; and predicting the life of the heater on a basis of the calculated resistance change amount or the calculated resistance change rate.

In the heater life prediction program described above, it is possible to configure that predicting the life of the heater is based on a relation between the calculated resistance change amount or the calculated resistance change rate and a preset threshold.

In the heater life prediction program described above, it is possible to configure that the heater life prediction program causes the computer to further perform a procedure for notifying a user that the heater is close to an end of the life.

In the heater life prediction program described above, it is possible to configure that the step in which the constant output control is executed is at least one of a film forming step of forming a film on the substrate, a temperature decreasing step of decreasing a temperature of the substrate, and an unloading step of unloading the substrate from the treatment chamber.

Embodiments of the present invention will be explained below with reference to the accompanying drawings. The embodiments do not limit the present invention.

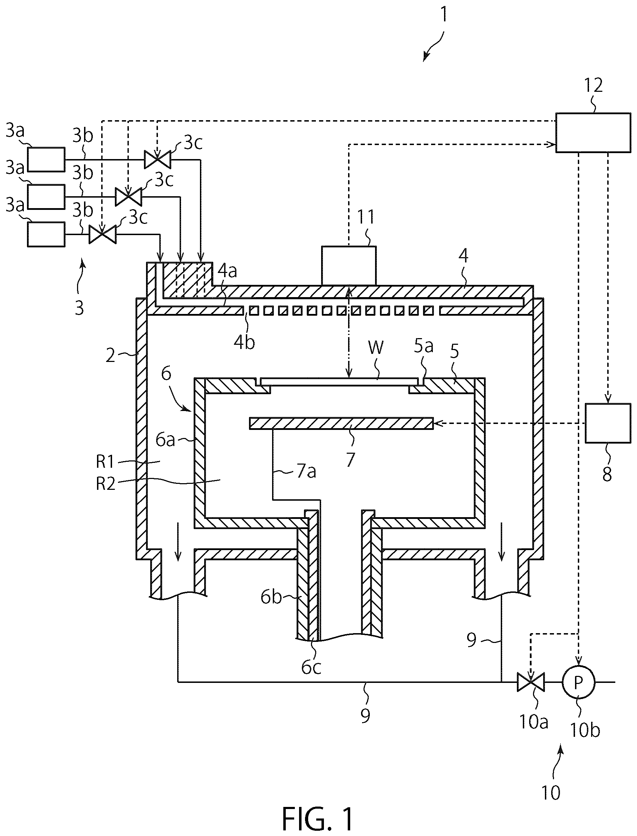

FIG. 1 is a diagram illustrating a film forming apparatus 1 according to the present embodiment. As illustrated in FIG. 1, the film forming apparatus 1 includes a chamber (film forming chamber) 2 as an example of a treatment chamber, a gas supplier 3, a source emitting portion 4, a susceptor 5, a rotator 6, a heater 7, a heater driver 8, a gas discharging portion 9, an ejection mechanism 10, a radiation thermometer 11, and a controller 12 as an example of a life predictor.

The chamber 2 performs film formation, which is an example of a treatment to wafers W which is an example of a substrate. The chamber 2 is a single-wafer chamber where film formation is performed to wafers W one by one. The wafers W are, for example, compound semiconductor wafers containing a compound semiconductor such as SiC and GaN. The wafers W are not limited to compound semiconductor wafers and may be, for example, silicon wafers containing single-crystal silicon. The chamber 2 has a shape (for example, a cylindrical shape) that can house a wafer W as a film formation target. The susceptor 5, the heater 7, a part of the rotator 6, and the like are housed in the chamber 2. A gate valve (not illustrated) controlled to open and close by the controller 12 is provided on the chamber 2. When the gate valve is opened, a transfer robot (not illustrated) can load and unload a wafer W with respect to the chamber 2.

The gas supplier 3 supplies a source gas to the wafer W in the chamber 2. The gas supplier 3 includes a plurality of gas reservoirs 3a that individually retain a plurality of gases, a plurality of gas pipes 3b that connect these gas reservoirs 3a to the source emitting portion 4, and a plurality of gas valves 3c that adjust the flow rates of the gases flowing through these gas pipes 3b. Each of the gas valves 3c is connected to an associated one of the gas pipes 3b. The gas valves 3c are controlled by the controller 12. Actual pipe arrangement may have other configurations in which a plurality of gas pipes are coupled, one gas pipe is branched into a plurality of gas pipes, branching and coupling of gas pipes are combined, and the like.

The source emitting portion 4 is positioned on the upper part of the chamber 2. The source gas supplied from the gas supplier 3 passes the source emitting portion 4 to be emitted into the chamber 2. The source gas (process gas) emitted into the chamber 2 is supplied to the surface of the wafer W, whereby a desired film is formed on the surface of the wafer W. The source gas to be used is not particularly limited to a particular type. The source gas can be variously changed according to the type of a film to be formed.

A shower plate 4a is provided on the bottom side of the source emitting portion 4. The shower plate 4a can be constituted of a metallic material such as stainless steel or an aluminum alloy. The gases from the gas pipes 3b are mixed in the source emitting portion 4 and pass through gas spouts 4b of the shower plate 4a to be supplied into the chamber 2. The source emitting portion 4 may be provided with a plurality of gas flow channels to separate the plural types of gases and supply the gases to the wafer W in the chamber 2 using nozzles or the like.

The structure of the source emitting portion 4 needs to be selected in view of in-plane uniformity of a formed film, consumption efficiency of the supplied source gas, reproducibility, manufacturing cost, and the like. However, the structure is not limited to a particular one and a known structure can be properly used as long as these requirements are met.

The susceptor 5 supports the wafer W in the chamber 2. The susceptor 5 is provided on the upper part of the rotator 6 that rotates while holding the susceptor 5. The susceptor 5 has a structure supporting the wafer W while placing the wafer W in a counterbore provided on an inner circumferential side of the susceptor 5. While the susceptor 5 has an annular shape having an opening at the center in the example illustrated in FIG. 1, the susceptor 5 is not limited thereto and may have a substantially flat-plate shape having no opening. The susceptor 5 may be a combination of a plurality of parts.

The heater 7 heats the susceptor 5 and the wafer W. The heater 7 heats the wafer W loaded in the chamber 2. A resistive heater constituted of carbon and the like is used as the heater 7.

The heater driver 8 drives the heater 7 by supplying power to the heater 7. For example, the heater driver 8 supplies a power-supply voltage to the heater 7 to pass a current through the heater 7 and cause the heater 7 to generate heat. The specific mode of the heater driver 8 is not limited to a particular one as long as it can drive the heater 7. For example, the heater driver 8 may have a transformer, a primary circuit connected to the primary side of the transformer, and a secondary circuit connected to the secondary side of the transformer. The primary circuit may have a thyristor and, for example, a commercial power-supply voltage may be applied to the primary circuit. The transformer may perform voltage conversion between an AC voltage on the primary circuit side and an AC voltage on the secondary circuit side. The heater 7 may be connected to the secondary circuit. A voltmeter and an ammeter may be connected to the secondary circuit. The voltmeter may measure the voltage applied to the heater 7 and the ammeter may measure the current flowing through the heater 7. The measurement values of the voltmeter and the ammeter may be supplied to the controller 12.

The gas discharging portion 9 discharges the gas in the chamber 2. The ejection mechanism 10 ejects the gas from the gas discharging portion 9. The ejection mechanism 10 ejects the reacted source gas from the inside of the chamber 2 through the gas discharging portion 9 and controls the inside of the chamber 2 to a desired pressure using an ejection valve 10a and a vacuum pump 10b.

The radiation thermometer 11 measures the temperature of the wafer W. The radiation thermometer 11 is provided on the top surface of the source emitting portion 4. The radiation thermometer 11 exposes the wafer W to light from a light source (not illustrated) and receives reflected light from the wafer W to measure reflected light intensity of the wafer W. The radiation thermometer 11 receives heat radiation light from a film growth face of the wafer W and measures heat radiation light intensity. While only one radiation thermometer 11 is illustrated in FIG. 1, a plurality of radiation thermometers 11 may be arranged on the top surface of the source emitting portion 4 to measure the temperatures of the film growth face of the wafer W at a plurality of positions (for example, on a center side and an outer circumference side).

The top surface of the source emitting portion 4 is provided with a light-permeable window (not illustrated). The light from the light source of the radiation thermometer 11, and the reflected light and the heat radiation light from the wafer W pass through the light-permeable window. The light-permeable window can have any shape such as a slit shape, a rectangular shape, or a circular shape. A transparent member to a wavelength range of light to be measured by the radiation thermometer 11 is used as the light-permeable window. For example, in a case of measuring temperatures from the room temperature to about 1500°C, it is preferable to measure the wavelengths of light from the visible region to the near-infrared region. In this case, quartz or the like is preferably used as the member of the light-permeable window. The result of the measurement of the temperature of the wafer W by the radiation thermometer 11 is used by the controller 12 that functions as a temperature adjustor to control power supply to the heater 7 by means of the heater driver 8 on the basis of the temperature of the wafer W.

The controller 12 includes a computer (not illustrated) that concentrically controls the film forming apparatus 1, and a storage (not illustrated) that stores a process control program, an apparatus history, and the like. The controller 12 controls the gas supplier 3, a rotating mechanism of the rotator 6, the ejection mechanism 10, heating of the wafer W by the heater 7, and the like by executing the process control program stored in the storage. The controller 12 controls the heater 7 to have an output to maintain the temperatures measured by the radiation thermometer 11 at a desired temperature, or a constant output previously determined.

The controller 12 also predicts the life of the heater 7 and notifies a user that the heater 7 is close to the end of the life as required.

A method of predicting the life of the heater 7 is explained below.

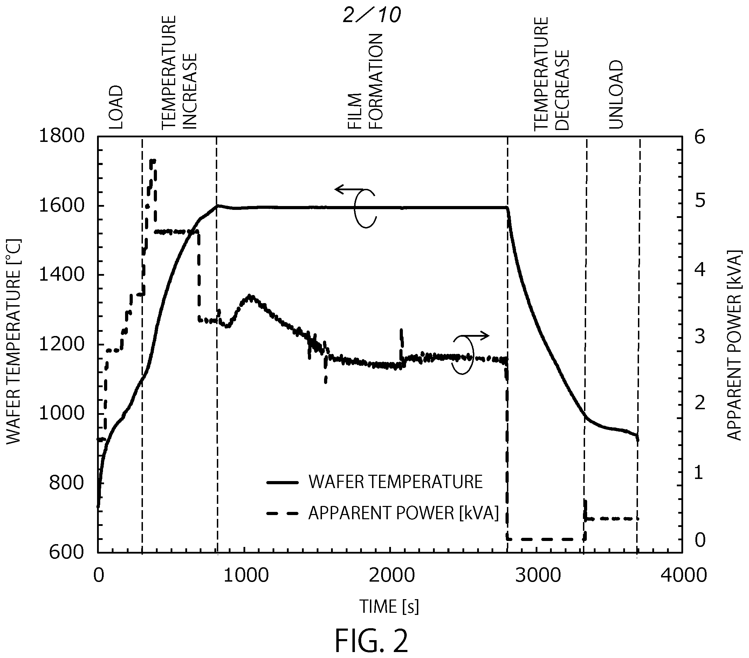

FIG. 2 is a diagram illustrating the wafer temperature and the apparent power throughout wafer W processing steps. As illustrated in FIG. 2, the treatment of the wafer W is composed of a sequence of treatment steps including a loading step, a temperature increasing step, a film forming step, a temperature decreasing step, and an unloading step. The loading step is a step in which a wafer W as a film formation target is loaded into the chamber 2. The temperature increasing step is a step in which the temperature of the wafer W is increased by heating the wafer W with the heater 7. The film forming step is a step in which a film is formed on the wafer W. For example, in the film forming step, a chemical reaction of the source gas supplied into the chamber 2 occurs on the surface of the heated wafer W, whereby an epitaxial film is formed on the surface of the wafer W. The temperature decreasing step is a step in which the temperature of the wafer W is decreased by causing the output of the heater 7 to be zero or considerably small. The unloading step is a step in which the output of the heater 7 is controlled to be constant and the wafer W is unloaded from the chamber 2.

The present inventors sequentially performed single-wafer treatments of a plurality of wafers W in a film forming apparatus having the same configuration as that illustrated in FIG. 1 and confirmed that the resistance value of the heater 7 varies among film formation treatments (among runs) for different wafers W in some of the treatment steps (that is, the loading step, the temperature increasing step, the film forming step, the temperature decreasing step, and the unloading step).

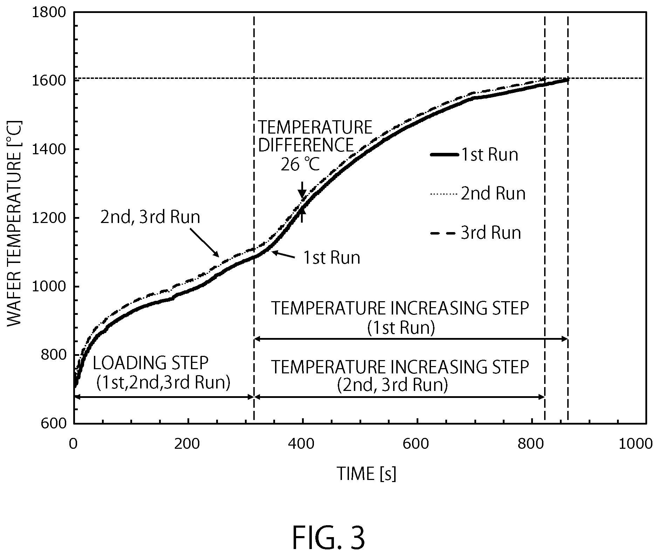

In the loading step and the temperature increasing step, the temperature of the wafer W at the same time differs between the film formation treatment of a first wafer and the film formation treatments of second and subsequent wafers carried in a state in which the temperature in the chamber 2 is kept as illustrated in FIG. 3. It is considered that this is because the temperature has been increased to about 800°C to 1600°C in the immediately-preceding film formation treatment and accordingly the temperatures of a reflector and an insulator in the chamber 2 have become high. The different temperatures of the wafers W at the same time between the film formation treatment of the first wafer and the film formation treatments of the subsequent wafers imply that the temperature of the heater 7 at the same time also differs. Since the resistance value of a heater depends on the heater temperature, it is considered that variation in the resistance value of the heater 7 is caused by the different temperatures of the heater 7 at the same time.

Another possible factor of the variation in the resistance value of the heater is individual differences of wafers. For example, when there is a difference in warp of wafers, the carrier concentration of wafers, the in-plane distribution thereof, or the like, it is considered that there may be contact between the wafer and the susceptor or variation in the infrared absorption coefficient on the wafer, or both thereof and that this results in variation of the heater output in wafer temperature control by means of the temperature adjuster. Therefore, the resistance value of the heater 7 varies in the film forming step to which the temperature control of the wafer W is applied.

In the temperature decreasing step, the temperature of the wafer W shows the same behavior among the wafers W. However, since the temperature is decreased by turning off the heater 7, the apparent power of the heater 7 becomes zero [kVA] or a considerably small value, and the resistance value of the heater 7 cannot be calculated or the calculation accuracy is significantly low. In the unloading step, the output of the heater 7 is controlled to be constant, so that variation in the temperature of the heater 7 among the film formation treatments (among runs) of different wafers W is small and fluctuation of the resistance value of the heater 7 is also small. That is, it can be said that predicting the life of the heater 7 in the unloading step where the constant output control is executed is preferable.

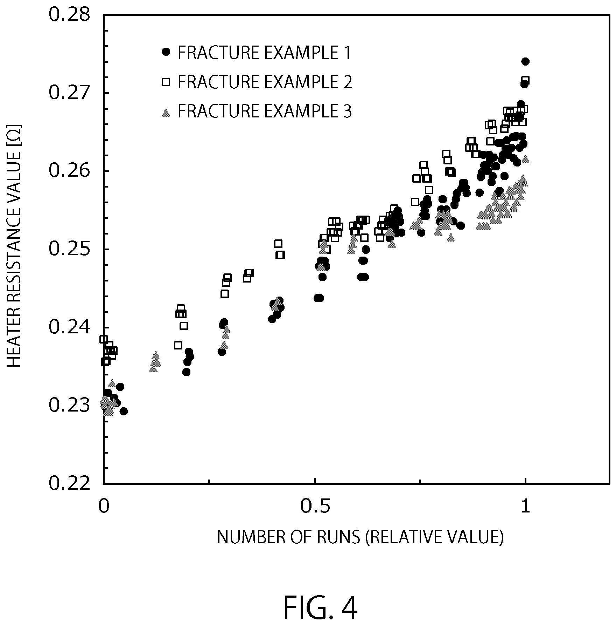

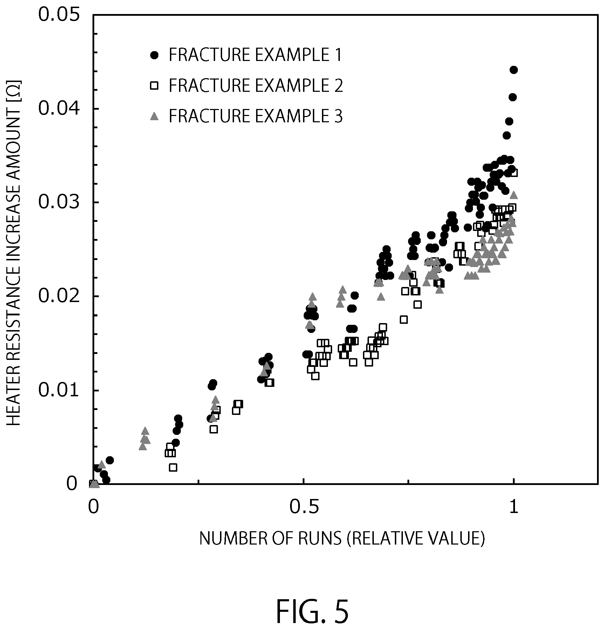

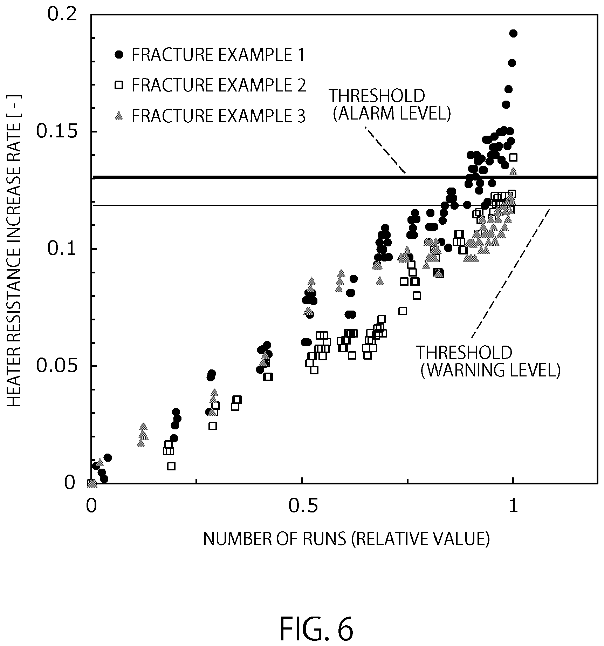

FIGS. 4 to 6 respectively illustrate changes of the resistance value of the heater, the resistance increase amount, and the resistance increase rate that are all calculated in the unloading step. FIG. 4 is a graph illustrating changes of the resistance value according to the number of runs (the number of treatments) for each heater as a comparative example. FIG. 5 is a graph illustrating changes of the resistance increase amount according to the number of runs for each heater according to the present embodiment. FIG. 6 is a graph illustrating changes of the resistance increase rate according to the number of runs for each heater according to the present embodiment. FIGS. 4 to 6 each illustrates data until just before fracture of the heater, where the horizontal axis represents the relative value to 1, which is the number of runs just before fracture.

As illustrated in FIG. 4, in a case of using the resistance value of the heater, there are differences in the initial value of the resistance value among different heaters and variation is generated in the heater resistance value just before fracture. In a case in which only the resistance value of the heater is used to predict the life of the heater, the initial value of the resistance value differs due to factors such as dimension tolerance at the time of manufacturing heaters. Therefore, a unique threshold cannot be set. On the other hand, in a case of using the resistance increase amount or the resistance increase rate as illustrated in FIGS. 5 and 6, influences of variation in the initial value of the resistance value among different heaters can be eliminated and a threshold for the resistance increase amount or the resistance increase rate that causes appropriate heater fracture (life) can be set. Furthermore, by comparing changes of the resistance increase amount or the resistance increase rate with the threshold, the number of runs (the end of the life of the heater) in which heater fracture occurs can be predicted. It is possible to set, for example, a threshold of a warning level to 0.113 and a threshold of an alarm level to 0.127 before reaching the end of the life as illustrated in FIG. 6. Criteria for setting the thresholds are as follows. The warning level is 85% of the value in an example in which the resistance increase rate just before fracture is the smallest (the value of example 3 in these examples), and the alarm level is 95% thereof. A user can freely set these thresholds. For example, a user can set lower values in view of risks for heater fracture, or can set higher values in expectation of reduction of the production cost. Setting two levels of the thresholds including the warning level and the alarm level enables the user to be sufficiently alerted. The end of the life of the heater can be predicted by setting appropriate thresholds for heater fracture as described above.

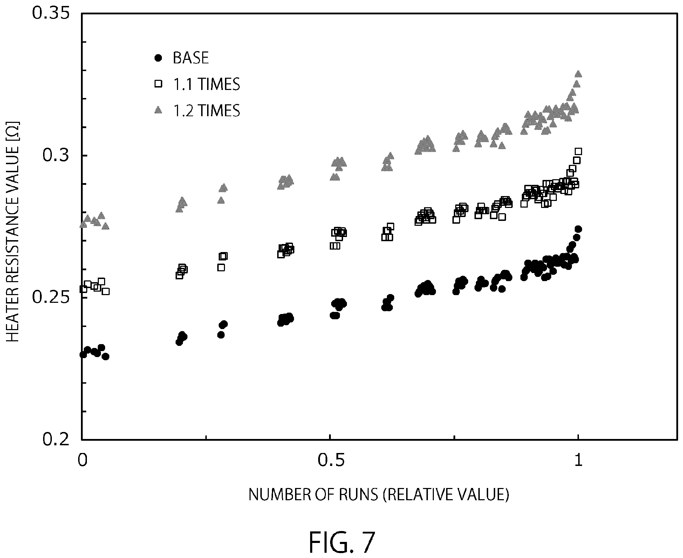

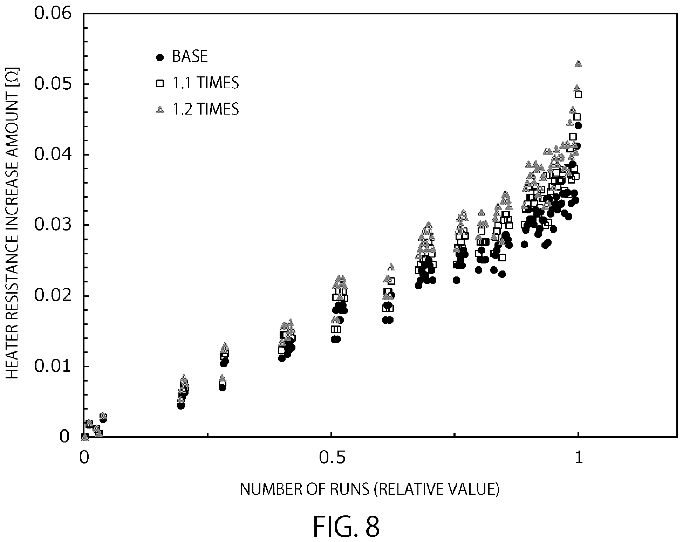

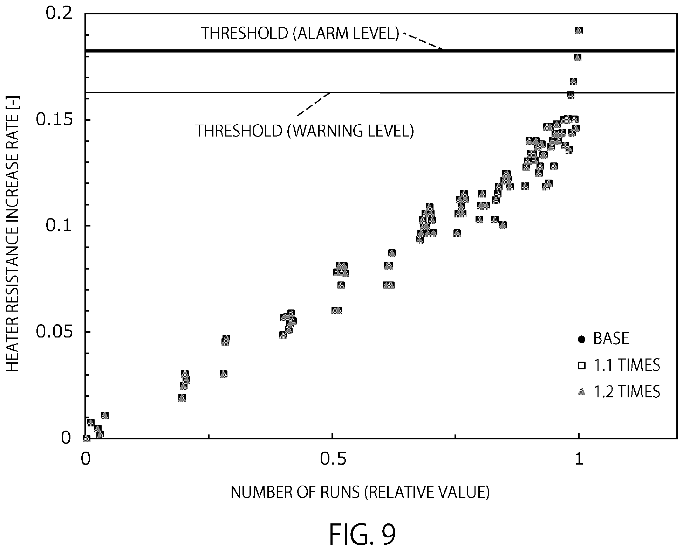

For example, in a case of a heater constituted of conductive thin films (for example, pyrolytic graphite and pyrolytic boron nitride) formed on the surface of a base material, the initial value of the resistance value easily changes by 10% or 20% depending on variation in the thicknesses of the thin films. Therefore, the resistance change amount changes 1.1 times or 1.2 times in some cases. In these cases, changes of the resistance value and the resistance increase amount differ according to examples as illustrated in FIGS. 7 and 8. However, as illustrated in FIG. 9, with use of changes of the resistance increase rate, influences of the individual differences of the heater caused by the above situation can be eliminated and appropriate thresholds for heater fracture can be set. For example, it is possible to set the threshold of the warning level to 0.163 and the threshold of the alarm level to 0.182.

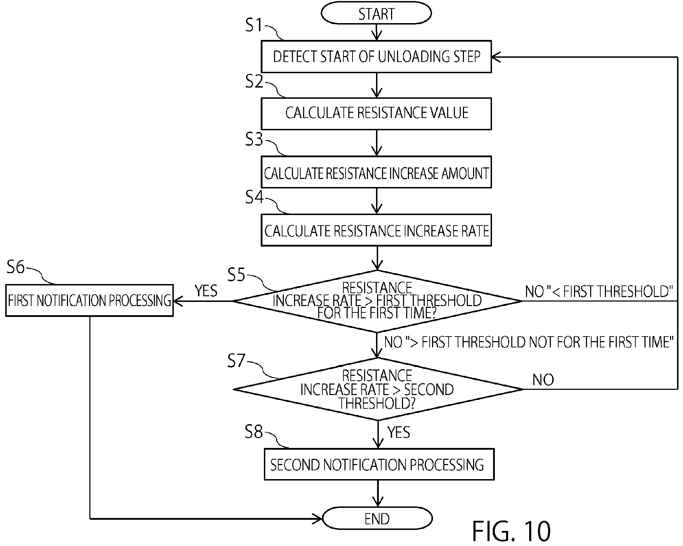

FIG. 10 is a flowchart illustrating a heater life prediction method according to the present embodiment. In the present embodiment, based on the above knowledge, the controller 12 calculates the resistance increase rate in the unloading step and predicts the life of the heater 7 on the basis of the calculated resistance increase rate. A specific prediction method of the life of the heater 7 is as follows.

FIG. 10 is a flowchart illustrating the heater life prediction method according to the present embodiment.

First, as illustrated in FIG. 10, the controller 12 detects start of the unloading step of a wafer W on the basis of the progress status of the treatment of the wafer W (Step S1).

After detecting start of the unloading step, the controller 12 calculates the resistance value of the heater 7 (Step S2).

After calculating the resistance value of the heater 7, the controller 12 calculates the resistance increase amount by calculating a difference between the calculated resistance value of the heater 7 and an initial value of the resistance value of the heater 7 calculated in advance (Step S3).

After calculating the resistance increase amount, the controller 12 calculates the resistance increase rate by dividing the resistance increase amount by the initial value of the resistance value of the heater 7 (Step S4). Processing at Steps S2 to S4 may be performed in one step.

After calculating the resistance increase rate, the controller 12 determines whether the resistance increase rate has exceeded a preset first threshold for the first time (Step S5). The first threshold is, for example, the threshold of the warning level described above.

When the resistance increase rate has exceeded the first threshold for the first time (Step S5: YES), the controller 12 predicts that the heater 7 is close to the end of the life and performs first notification processing to a user (Step S6). For example, the controller 12 performs the first notification processing using an alarm sound source or a display device (both not illustrated) connected to the controller 12. The first notification processing is, for example, causing the alarm sound source to ring and alerting by voice that the heater 7 is close to the fracture period, or displaying that the heater 7 is close to the fracture period on the display device to call for attention.

On the other hand, when the resistance increase rate is not above the first threshold (Step S5: NO "< the first threshold"), the controller 12 repeats calculation of the resistance value of the heater 7 after detecting start of the unloading step again (Steps S2 to S4).

After performing the first notification processing, the controller 12 determines, after detecting start of the next unloading step, whether the resistance increase rate has exceeded a preset second threshold as a case in which it is not the first time for the resistance increase rate to exceed the first threshold at Step S5 (Step 5: NO "> the first threshold is not the first time") (Step S7). The second threshold is a threshold larger than the first threshold and is, for example, the threshold of the alarm level described above.

When the resistance increase rate exceeds the second threshold (Step S7: YES), the controller 12 predicts that the heater 7 is closer to the end of the life and performs second notification processing to the user (Step S8). The controller 12 performs the second notification processing using, for example, the alarm sound source or the display device (both not illustrated) connected to the controller 12. In the second notification processing, notifying that the heater 7 is closer to the end of the life by ringing or display in a manner enabling to inform that the heater 7 is closer to fracture is possible. In the second notification processing, it is possible to cause the heater driver 8 to stop power supply to the heater 7.

On the other hand, when the resistance increase rate is not above the second threshold (Step S7: NO), the controller 12 repeats the calculation of the resistance value of the heater 7 after detecting start of the unloading step again (Steps S2 to S4).

As described above, according to the present embodiment, the resistance increase rate is calculated in the unloading step in which the output control on the heater 7 is executed, and the life of the heater 7 can be predicted at a high accuracy on the basis of the calculated resistance increase rate while being hardly affected by dimension tolerance of the heater 7 and individual differences of the deterioration tendency. Accordingly, unexpected fracture of the heater 7 can be prevented and occurrence of defective products due to heater fracture and downtime caused by unforeseen addressing of apparatus restoration can be suppressed.

The present embodiment is not limited to the examples described above and are applicable to various modifications illustrated as below.

### (First modification)

In a case in which the tendency to heater deterioration does not change, the life of the heater 7 may be predicted based on the resistance increase amount calculated in the unloading step. At that time, a plurality of thresholds may be set as thresholds for the resistance increase amount to notify the user similarly to the embodiment. The life of the heater 7 can be predicted highly accurately similarly to the embodiment.

### (Second modification)

Under certain conditions, the resistance calculation may be performed in a step other than the unloading step. For example, in a case in which there is a period when the heater output is controlled to be constant in the film forming step, the life of the heater 7 can be predicted based on the resistance increase rate or the resistance increase amount of the heater 7 calculated in the constant output control period in the film forming step. Also in this case, the life of the heater 7 can be predicted highly accurately similarly to the embodiment.

### (Third modification)

In a case in which the output of the heater 7 is controlled to be constant, for example, so as to stepwise decrease the heater output, without causing the heater output to be zero in the temperature decreasing step between the treatments of different wafers W, the life of the heater 7 can be predicted based on the resistance increase rate or the resistance increase amount of the heater 7 calculated in the temperature decreasing step. Also in this case, the life of the heater 7 can be predicted highly accurately similarly to the embodiment. Furthermore, by stepwise decreasing the output of the heater 7, the environments in the furnace can be gradually changed and load on the wafer W can be suppressed. Accordingly, deformation of the wafer W resulting from thermal stress due to temperature differences in the plane of the wafer W can be reduced.

The scope of the invention is defined by the appended claims.

## Claims

1. A heater life prediction method comprising predicting a life of a heater (7) in a semiconductor manufacturing apparatus comprising a treatment chamber (2) in which a treatment of a substrate is performed, and the heater (7) configured to heat the substrate loaded into the treatment chamber, wherein prediction of the life of the heater (7) comprises:
calculating a resistance change amount being a difference between a resistance value of the heater (7) and an initial value of the resistance value, or a resistance change rate obtained by dividing the resistance change amount by the initial value in a step in which constant output control is executed on the heater (7); and
predicting the life of the heater (7) on a basis of the calculated resistance change amount or the calculated resistance change rate, **characterized in that**
the step in which the constant output control is executed is an unloading step of unloading the substrate from the treatment chamber.

2. The method of Claim 1, wherein the life of the heater (7) is predicted based on a relation between the resistance change amount or the resistance change rate and a preset threshold.

3. The method of Claim 2, further comprising notifying a user that the heater (7) is close to an end of the life.

4. A heat treatment apparatus comprising:
a treatment chamber in which a treatment of a substrate is performed;
a heater (7) configured to heat the substrate loaded into the treatment chamber; and
a life predictor (12) configured to predict a life of the heater (7),
wherein the life predicto **is** configured to calculate a resistance change amount being a difference between a resistance value of the heater and an initial value of the resistance value, or a resistance change rate obtained by dividing the resistance change amount by the initial value in a step in which constant output control is executed on the heater, and predict the life of the heater on a basis of the calculated resistance change amount or the calculated resistance change rate,
**characterized in that**
the step in which the constant output control is executed is an unloading step of unloading the substrate from the treatment chamber.

5. The apparatus of Claim 4, wherein the life predictor predicts the life of the heater on a basis of a relation between the calculated resistance change amount or the calculated resistance change rate and a preset threshold.

6. The apparatus of Claim 5, wherein the life predictor notifies a user that the heater is close to an end of the life.

7. The apparatus of Claim 4, wherein the step in which the constant output control is executed is at least one of a film forming step of forming a film on the substrate, a temperature decreasing step of decreasing a temperature of the substrate, and an unloading step of unloading the substrate from the treatment chamber.

8. A heater life prediction program causing a computer to perform a procedure for predicting a life of a heater in a heat treatment apparatus comprising a treatment chamber in which a treatment of a substrate is performed, and the heater configured to heat the substrate loaded into the treatment chamber, wherein the procedure comprising:
calculating a resistance change amount being a difference between a resistance value of the heater and an initial value of the resistance value, or a resistance change rate obtained by dividing the resistance change amount by the initial value in a step in which constant output control is executed on the heater; and
predicting the life of the heater on a basis of the calculated resistance change amount or the calculated resistance change rate, **characterized in that**
the step in which the constant output control is executed is an unloading step of unloading the substrate from the treatment chamber.

9. The heater life prediction program of Claim 8, wherein predicting the life of the heater is based on a relation between the calculated resistance change amount or the calculated resistance change rate and a preset threshold.

10. The heater life prediction program of Claim 9, wherein the heater life prediction program causes the computer to further perform a procedure for notifying a user that the heater is close to an end of the life.

11. The heater life prediction program of Claim 8, wherein the step in which the constant output control is executed is at least one of a film forming step of forming a film on the substrate, a temperature decreasing step of decreasing a temperature of the substrate, and an unloading step of unloading the substrate from the treatment chamber.

## Patentansprüche

1. Ein Heizungslebensdauer-Vorhersageverfahren umfassend das Vorhersagen einer Lebensdauer einer Heizung (7) in einer Halbleiterherstellungsvorrichtung, umfassend eine Behandlungskammer (2), in der eine Behandlung eines Substrats durchgeführt wird, und die Heizung (7), konfiguriert zum Erhitzen des in die Behandlungskammer geladenen Substrats, wobei
die Vorhersage der Lebensdauer der Heizung (7) umfasst:
Berechnen eines Widerstandsänderungsbetrags, der eine Differenz zwischen einem Widerstandswert der Heizung (7) und einem Anfangswert des Widerstandswerts ist, oder einer Widerstandsänderungsrate, die durch Dividieren des Widerstandsänderungsbetrags durch den Anfangswert in einem Schritt erhalten wird, in dem eine Konstantleistungssteuerung an der Heizung (7) ausgeführt wird; und
Vorhersagen der Lebensdauer der Heizung (7) auf einer Basis des berechneten Widerstandsänderungsbetrags oder der berechneten Widerstandsänderungsrate,
**dadurch gekennzeichnet, dass**
der Schritt, in dem die Konstantleistungssteuerung ausgeführt wird, ein Entladeschritt des Entladens des Substrats aus der Behandlungskammer ist.

2. Das Verfahren nach Anspruch 1, wobei die Lebensdauer der Heizung (7) basierend auf einer Beziehung zwischen dem Widerstandsänderungsbetrag oder der Widerstandsänderungsrate und einem voreingestellten Schwellenwert vorhergesagt wird.

3. Das Verfahren nach Anspruch 2, ferner umfassend das Benachrichtigen eines Benutzers, dass die Heizung (7) nahe an einem Ende der Lebensdauer ist.

4. Eine Wärmebehandlungsvorrichtung, umfassend:
eine Behandlungskammer, in der eine Behandlung eines Substrats durchgeführt wird;
eine Heizung (7), konfiguriert zum Erhitzen des in die Behandlungskammer geladenen Substrats; und
einen Lebensdauervorhersager (12), konfiguriert zum Vorhersagen einer Lebensdauer der Heizung (7),
wobei der Lebensdauervorhersager konfiguriert ist zum Berechnen eines Widerstandsänderungsbetrag, der eine Differenz zwischen einem Widerstandswert der Heizung und einem Anfangswert des Widerstandswerts ist, oder eine Widerstandsänderungsrate, die durch Dividieren des Widerstandsänderungsbetrags durch den Anfangswert in einem Schritt erhalten wird, in dem eine Konstantleistungssteuerung an der Heizung ausgeführt wird, berechnet, und
Vorhersagen der Lebensdauer der Heizung auf einer Basis des berechneten Widerstandsänderungsbetrags oder der berechneten Widerstandsänderungsrate,
**dadurch gekennzeichnet, dass**
der Schritt, in dem die Konstantleistungssteuerung ausgeführt wird, ein Entladeschritt des Entladens des Substrats aus der Behandlungskammer ist.

5. Die Vorrichtung nach Anspruch 4, wobei der Lebensdauervorhersager die Lebensdauer der Heizung auf einer Basis einer Beziehung zwischen dem berechneten Widerstandsänderungsbetrag oder der berechneten Widerstandsänderungsrate und einem voreingestellten Schwellenwert vorhersagt.

6. Die Vorrichtung nach Anspruch 5, wobei der Lebensdauervorhersager einen Benutzer benachrichtigt, dass die Heizung nahe an einem Ende der Lebensdauer ist.

7. Die Vorrichtung nach Anspruch 4, wobei der Schritt, in dem die Konstantleistungssteuerung ausgeführt wird, mindestens einer eines Filmbildungsschritts des Bildens eines Films auf dem Substrat, eines Temperaturabsenkungsschritts des Absenkens einer Temperatur des Substrats und eines Entladeschritts des Entladens des Substrats aus der Behandlungskammer ist.

8. Ein Heizungslebensdauer-Vorhersageprogramm, das einen Computer veranlasst, ein Heizungslebensdauer-Vorhersageverfahren in einer Wärmebehandlungsvorrichtung durchzuführen, umfassend eine Behandlungskammer, in der eine Behandlung eines Substrats durchgeführt wird, und die Heizung, konfiguriert zum Erhitzen des in die Behandlungskammer geladenen Substrats,
wobei das Verfahren umfasst:
Berechnen eines Widerstandsänderungsbetrags, der eine Differenz zwischen einem Widerstandswert der Heizung und einem Anfangswert des Widerstandswerts ist, oder einer Widerstandsänderungsrate, die durch Dividieren des Widerstandsänderungsbetrags durch den Anfangswert in einem Schritt erhalten wird, in dem eine Konstantleistungssteuerung an der Heizung ausgeführt wird; und
Vorhersagen der Lebensdauer der Heizung auf einer Basis des berechneten Widerstandsänderungsbetrags oder der berechneten Widerstandsänderungsrate,
**dadurch gekennzeichnet, dass**
der Schritt, in dem die Konstantleistungssteuerung ausgeführt wird, ein Entladeschritt des Entladens des Substrats aus der Behandlungskammer ist.

9. Das Heizungslebensdauer-Vorhersageprogramm nach Anspruch 8, wobei das Vorhersagen der Lebensdauer der Heizung auf einer Beziehung zwischen dem berechneten Widerstandsänderungsbetrag oder der berechneten Widerstandsänderungsrate und einem voreingestellten Schwellenwert basiert.

10. Das Heizungslebensdauer-Vorhersageprogramm nach Anspruch 9, wobei das Programm zur Vorhersage der Lebensdauer einer Heizung den Computer veranlasst, ferner ein Verfahren zum Benachrichtigen eines Benutzers durchzuführen, dass die Heizung nahe an einem Ende der Lebensdauer ist.

11. Das Heizungslebensdauer-Vorhersageprogramm nach Anspruch 8, wobei der Schritt, in dem die Konstantleistungssteuerung ausgeführt wird, mindestens einer eines Filmbildungsschritts des Bildens eines Films auf dem Substrat, eines Temperaturabsenkungsschritts des Absenkens einer Temperatur des Substrats und eines Entladeschritts des Entladens des Substrats aus der Behandlungskammer ist.

## Revendications

1. Procédé de prédiction de durée de vie d'élément chauffant, comprenant une prédiction d'une durée de vie d'un élément chauffant (7) dans un appareil de fabrication de semi-conducteur comprenant une chambre de traitement (2) dans laquelle un traitement d'un substrat est effectué, et l'élément chauffant (7) est configuré pour chauffer le substrat chargé dans la chambre de traitement, dans lequel
une prédiction de la durée de vie de l'élément chauffant (7) comprend :
le calcul d'une quantité de variation de résistance étant une différence entre une valeur de résistance de l'élément chauffant (7) et une valeur initiale de la valeur de résistance, ou d'un taux de variation de résistance obtenu en divisant la quantité de variation de résistance par la valeur initiale, au cours d'une étape au cours de laquelle une commande de puissance constante est appliquée à l'élément chauffant (7) ; et
la prédiction de la durée de vie de l'élément chauffant (7) sur une base de la quantité de variation de résistance calculée ou du taux de variation de résistance calculé, **caractérisé en ce que**
l'étape au cours de laquelle la commande de puissance constante est exécutée est une étape de déchargement consistant à retirer le substrat de la chambre de traitement.

2. Procédé selon la revendication 1, dans lequel la durée de vie de l'élément chauffant (7) est prédite sur la base d'une relation entre la quantité de variation de résistance ou le taux de variation de résistance et un seuil prédéfini.

3. Procédé selon la revendication 2, comprenant en outre le fait d'avertir un utilisateur que l'élément chauffant (7) est proche d'une fin de La durée de vie.

4. Appareil de traitement thermique comprenant :
une chambre de traitement dans laquelle un traitement d'un substrat est effectué ;
un élément chauffant (7) configuré pour chauffer le substrat chargé dans la chambre de traitement ; et
un dispositif de prédiction de durée de vie (12) configuré pour prédire une durée de vie de l'élément chauffant (7),
dans lequel le dispositif de prédiction de durée de vie est configuré pour
calculer une quantité de variation de résistance étant une différence entre une valeur de résistance de l'élément chauffant et une valeur initiale de la valeur de résistance, ou un taux de variation de résistance obtenu en divisant la quantité de variation de résistance par la valeur initiale au cours d'une étape au cours de laquelle une commande de puissance constante est appliquée à l'élément chauffant, et
prédire la durée de vie de l'élément chauffant sur la base de la quantité de variation de résistance calculée ou du taux de variation de résistance calculé,
**caractérisé en ce que** l'étape au cours de laquelle la commande de puissance constante est exécutée est une étape de déchargement consistant à retirer le substrat de la chambre de traitement.

5. Appareil selon la revendication 4, dans lequel le dispositif de prédiction de durée de vie prédit la durée de vie de l'élément chauffant sur la base d'une relation entre la quantité de variation de résistance calculée ou le taux de variation de résistance calculé et un seuil prédéfini.

6. Appareil selon la revendication 5, dans lequel le dispositif de prédiction de durée de vie avertit un utilisateur que l'élément chauffant est proche d'une fin de la durée de vie.

7. Appareil selon la revendication 4, dans lequel l'étape au cours de laquelle la commande de puissance constante est exécutée est au moins une parmi une étape de formation de film consistant à former un film sur le substrat, une étape de diminution de température consistant à diminuer une température du substrat, et une étape de déchargement consistant à retirer le substrat de la chambre de traitement.

8. Programme de prédiction de durée de vie d'élément chauffant, amenant un ordinateur à exécuter une procédure de prédiction d'une durée de vie d'un élément chauffant dans un appareil de traitement thermique comprenant une chambre de traitement dans laquelle un traitement d'un substrat est effectué, et l'élément chauffant est configuré pour chauffer le substrat chargé dans la chambre de traitement,
dans lequel la procédure comprend :
le calcul d'une quantité de variation de résistance étant une différence entre une valeur de résistance de l'élément chauffant et une valeur initiale de la valeur de résistance, ou d'un taux de variation de résistance obtenu en divisant la quantité de variation de résistance par la valeur initiale au cours d'une étape au cours de laquelle une commande de puissance constante est appliquée à l'élément chauffant ;
et
la prédiction de la durée de vie de l'élément chauffant sur la base de la quantité de variation de résistance calculée ou du taux de variation de résistance calculé, **caractérisée en ce que**
l'étape au cours de laquelle la commande de puissance constante est effectuée est une étape de déchargement consistant à retirer le substrat de la chambre de traitement.

9. Programme de prédiction de durée de vie d'élément chauffant selon la revendication 8, dans lequel la prédiction de la durée de vie de l'élément chauffant est basée sur une relation entre la quantité de variation de résistance calculée ou le taux de variation de résistance calculé et un seuil prédéfini.

10. Programme de prédiction de durée de vie d'élément chauffant selon la revendication 9, dans lequel le programme de prédiction de durée de vie d'élément chauffant amène l'ordinateur à exécuter en outre une procédure visant à avertir un utilisateur que l'élément chauffant est proche d'une fin de la durée de vie.

11. Programme de prédiction de durée de vie d'élément chauffant selon la revendication 8, dans lequel l'étape au cours de laquelle la commande de puissance constante est exécutée correspond à au moins une parmi des étapes suivantes : une étape de formation de film consistant à former un film sur le substrat, une étape de diminution de température consistant à diminuer une température du substrat, et une étape de déchargement consistant à retirer le substrat de la chambre de traitement.
